# EUROPEAN PATENT APPLICATION

(11) **EP 4 779 873 A1**
(43) Date of publication of application: **22.07.2026**
(21) Application number: 25151884.1
(22) Date of filing: 15.01.2025
(51) Int. Cl.: H03K 17/96

(54) **INTERACTION DEVICE FOR A HOUSEHOLD APPLIANCE**

(71) Applicant: BSH Hausgeräte GmbH, 81739 München (DE)
(72) Inventor: Namespetra, Milos, 08212 Kapusany (SK); Nietiedt, Eric, 13353 Berlin (DE)

(57) **Abstract**

An interaction device (105) for a household appliance (100) comprises a retaining element (205); an operating element (215); and a foam element (220), which is arranged flat between the retaining element (205) and the operating element (215). The retaining element (205) is designed to be attached to the household appliance (100) in such a way that the operating element (215) rests against a transparent panel(125) of the household appliance (100) and the foam element (220) is compressed between the retaining element (205) and the transparent panel (125).

## Description

The present invention relates to a household appliance. In particular, the invention relates to an interaction device for the household appliance.

A household appliance comprises an interaction device by means of which a person can control the household appliance. In particular, the interaction device can comprise an input device with a capacitive proximity switch. The person can, for example, bring a finger close to an electrode of the proximity switch, whereby the presence of the finger in the area of the electrode is determined on the basis of a change in charge or a change in the capacitance of the electrode. An associated function of the household appliance can then be controlled accordingly.

The household appliance can comprise a transparent panel behind which the interaction device is to be attached. The electrode should be as close as possible to the pane in order to increase sensitivity but mechanical stress to the interaction device should be avoided. Various suggestions have been made for such a mounting. However, in most of the proposed solutions, a contact force of an element with such an electrode on the transparent panel is not uniform, or it cannot be guaranteed that the contact force remains within a predetermined range.

An underlying task of the present invention is to provide an improved interaction device for a household appliance. The invention solves this task by means of the objects of the independent claims. Subclaims indicate preferred embodiments.

According to a first aspect of the present invention, an interaction device for a household appliance comprises a retaining element; an operating element; and a foam element. The foam element is arranged flat between the retaining element and the operating element, and the retaining element is adapted to be attached to the household appliance such that the operating element abuts against a transparent panel of the household appliance and the foam element is compressed between the retaining element and the transparent panel.

The foam element can be used to improve the surface contact of the operating element with the transparent panel or pane. A mounting tolerance of the retaining element in relation to the household appliance or in relation to the transparent panel can be compensated for by the foam element. The operating element can be held better against the window panel and an air gap can be prevented from forming between the operating element and the window panel. The foam element can essentially cover an area of the operating element that is in contact with the panel. The operating element can be essentially flat, preferably with a constant thickness, and the foam element can press the operating element flat against the pane. The dimensions of the pane are usually larger than the dimensions of the operating element. The operating element can be securely accommodated behind the panel so that it is protected from external influences such as dust, moisture or grease. At the same time, the operating element can be very close to the transparent panel so that it can be easily operated through the panel.

The foam element is usually brick-shaped and comprises a foam that can be open-cell, closed-cell or mixed-cell. Preferably, the foam is essentially homogeneous so that it has uniform elastic properties. A compression hardness of the foam, which indicates the pressure at which the foam deforms by 10%, may be less than about 15 kPa, in which case the foam is considered soft, or between about 15 kPa and about 80 kPa, in which case the foam is considered semi-solid. The foam is preferably made of a plastic, for example PP-E foam.

The operating element preferably comprises a capacitive button. The operating element can comprise an electrode that a person can actuate through the pane, for example by bringing a finger or another part of the body close to the electrode. The electrode can be attached to a carrier material, usually a printed circuit board or a conductive foil. The transparent panel lies between the electrode and the body part. An electronic evaluation unit determines a change in charge or capacitance on the electrode and in this way senses presence of the part of the person's body. A function of the household appliance can be controlled depending on a sensed presence or actuation.

The foam element is preferably dimensioned in such a way that a contact pressure between the transparent panel and the operating element lies within a predetermined range. The contact pressure can be dependent on a tolerance, aging or temperature. Due to the elasticity of the foam element, the contact pressure can still be kept within the range. Since the foam element acts on the back surface of the operating element, the contact pressure can be essentially constant over the front surface of the operating element.

The transparent panel and the operating element can lie against each other along a plane. One surface of the transparent panel and one surface of the operating element can each be flat and lie against each other.

It is preferred that the operating element is flexible. The operating element can be designed as a flat plate or foil with an essentially constant thickness. It is particularly preferred that the operating element comprises a flexible conductor foil with conductor tracks. A conductor track can be affixed to a carrier material in such a way that it forms a structure that can be used as an electrode for a capacitive button. Several conductor tracks and several electrode structures can be provided. Evaluation electronics can be mounted on a separate circuit board, which can be electrically connected to the operating element, for example by means of a plug-gable connector. A conductor track on the carrier material can be covered to provide electrical insulation.

The foam element can be connected to the operating element over a large area. In particular, a bonding connection can be selected, for example by means of welding or injection molding. The foam element can be connected to the retaining element in a similar way. A bonding connection can also be selected here.

The foam element can be attached to the operating element and/or the retaining element by means of glueing, especially with a double-sided adhesive film. The adhesive film can create a two-dimensional material bond. In one embodiment, the adhesive film is bonded to the foam element and covered with a protective film, resulting in a unit that can be handled separately. The protective film can be removed in order to bond the foam element to the operating element or the retaining element. This allows the foam element to be fitted to the operating element or retaining element easily and without tools. The interaction device can be manufactured easily and securely, and the foam element can be connected to the retaining element or the operating element in a reliable process. The adhesive film can be applied to the foam element cost-effectively and, if desired, automatically, so that the manufacturing costs of the interaction device can be advantageously low.

In one embodiment, an optical display is attached to the retaining element, and the optical display is designed to be viewed through the transparent panel. For this purpose, the panel is preferably transparent at least in sections in the area of the optical display. In the area of the operating element, the panel can alternatively be transparent or opaque. The operating element and the display can be separated from a user by the panel. The operating element and the optical display can be located on the inside of the household appliance, while an operating person is located on the outside. The operating element can be an input device and the optical display an output device. By combining the two devices, a bidirectional interaction between the operator and the household appliance can be realized.

It is also preferred that the optical display is flush with the operating element. This can apply in particular if the interaction device is inserted on the household appliance so that the operating element is pressed against the panel. If the interaction device is removed from the household appliance, the operating element can be higher than the optical display.

The interaction device can also include a control device that is set up to control the household appliance depending on an operation of the operating element and content shown on the display in the area of the operation. The operation may comprise bringing a bodily part of a person close to the operating element. The bodily part may or may not be in contact with the transparent panel during operation. In one embodiment, an indication of a function of the household appliance may be shown on the display. If an operation is then registered in the area of the indication, the predetermined function can be executed. In this way, a dynamic operating concept of the household appliance can be supported or implemented using the interaction device.

According to a further aspect of the present invention, a household appliance comprises an interaction device as described herein. In particular, the domestic appliance may comprise a laundry care appliance, for example a washing machine or a tumble dryer. The household appliance may also comprise, for example, a kitchen appliance, for example a dishwasher, a stove, an oven, a coffee maker, an extractor hood or a food processor.

It is particularly preferred that the transparent panel is enclosed by a front panel of the household appliance. The appliance front may comprise a front panel that supports the transparent panel. In one embodiment, the front panel is comprised by or recessed into a face of the appliance. The interaction device may be attached to the front of the appliance from a later inside of the domestic appliance. After affixing the interaction device to the front panel, the panel can be attached to the household appliance. In this way, the household appliance can be easily and reliably fitted with the interaction device. The interaction device can form a separately manageable unit together with the front panel, appliance front or appliance cover, which can be easily attached to the household appliance or removed from it again for maintenance.

Non-limiting embodiments of the invention will now be described in more detail with reference to the accompanying figures, in which:
- Figure 1: a household appliance with an interaction device;
- Figure 2: an exploded view of an interaction device; and
- Figures 3-5: views of an operating element of an interaction device
represent.

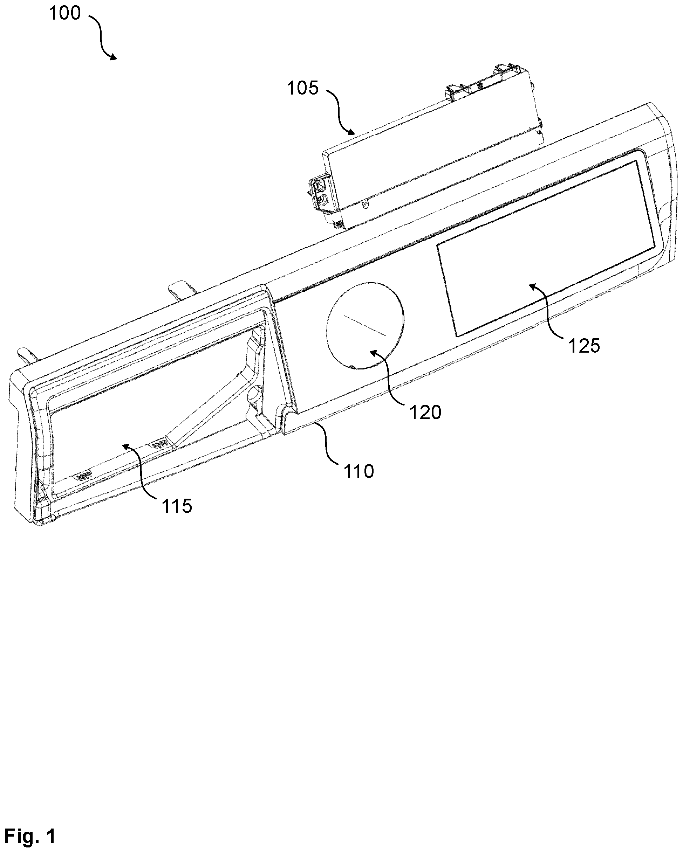

Figure 1 shows a household appliance 100 with an interaction device 105. The household appliance 100 comprises, byway of example, a washing machine, of which only a front panel 110 is shown. The appliance front 110 comprises a panel, which can usually be made of plastic. A recess 115 for a detergent drawer can be seen in a left-hand area. A further recess 120 for a rotatable control knob can be seen in a central area. In a right-hand area, a transparent panel 125 is recessed into the appliance front 110. The transparent panel 125 can also be formed integrally with the appliance front 110. An outer side of the household appliance 100 is facing the viewer of Figure 1. An operator can look through the pane 125 at the interaction device 105 after it has been attached to the appliance front 110 in the area of the pane 125. For attachment, the interaction device 105 and/or the appliance front 110 can each have corresponding structures that can be connected to one another. A connection can be made, for example, by clipping, screwing, riveting or by any other suitable connection technique.

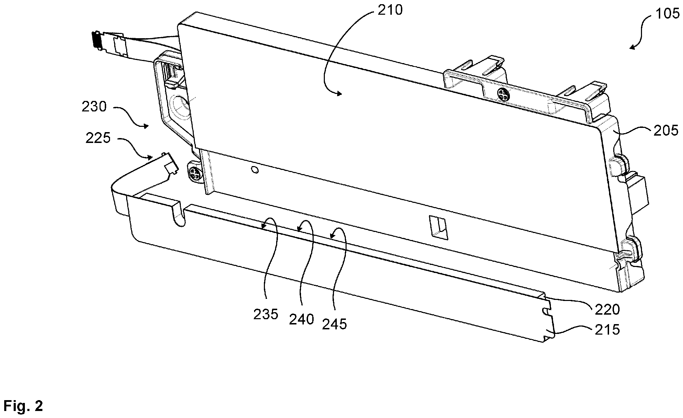

Figure 2 shows an exploded view of an interaction device 105. The interaction device 105 comprises a retaining element 205, to which an optical display 210 is attached, an operating element 215 and a foam element 220. The foam element 220 is connected to the operating element 215, but is shown lifted off the retaining element 205.

The retaining element 205 preferably comprises a flat contact surface for the foam element 220. The foam element 220 preferably has a substantially constant thickness and is designed to lie between the retaining element 205 and the operating element 215. The foam element 220 is elastic so that it resiliently supports the operating element 215 relative to the retaining element 205. The contact area on the retaining element 205 can be laterally limited, for example by a rib or an edge, in order to define a lateral or vertical position of the operating element 215 and/or the foam element 220. Further optionally, a retaining structure can be provided which can engage in the operating element 215 in order to define the horizontal or vertical position.

In the embodiment shown, the operating element 215 comprises a conductive foil which has a preferred thickness of about 1 mm or less. The conductor foil is flexible and usually carries one or more conductor tracks. An electronic part may be affixed to a conductor track. An electrical connection 225 can be formed at one end, which can be connected to a control device 230, which in the illustrated embodiment is also attached to the holding element 205. Due to the flexibility of the conductive foil, the electrical connection 225 can be attached to the control device 230 after the operating element 215 has been placed on the retaining element 205 by means of the foam element 220.

In the embodiment shown, the operating element 215 is bonded over its rear surface to the foam element 220. For this purpose, a first double-sided adhesive film 235 is provided, which lies between the operating element 215 and the foam element 220. To attach the foam element 220 to the retaining element 205, a second double-sided adhesive film 240 can be provided, which is initially only attached to the foam element 220 in the illustration of Figure 2. Until it is mounted on the retaining element 205, the second double-sided adhesive film 240 can be covered by means of a protective film 245. If the protective film 245 is removed, the foam element 220 can be attached over its surface to the retaining element 205 by means of the second double-sided adhesive film 240. It should be noted that instead of an adhesive film 235, 240, another connection technique can also be used between the holding element 205 and the foam element 220 or between the latter and the operating element 215. Preferably, a materially bonded and flat connection is produced.

Further optionally, the operating element 215 can be connected to the transparent panel 125. For example, a transparent double-sided adhesive film can be used for this purpose, which can also be covered by means of a protective film before the interaction device 105 is mounted on the household appliance 100 or on the front of the appliance 110.

The interaction device 105 may be attached to the front of the device 110 in a force-fit or form-fit manner. Figure 2 shows various connecting elements on the retaining element 205, which can engage in corresponding structures on the front of the device 110. Preferably, a screw is introduced through a recess in the retaining element 205 into a corresponding receptacle on the front of the device 110 in order to permanently attach the interaction device 105 to the front of the device 110. Such a recess can be seen in Figure 2 in the left-hand area, near the electrical connection 225.

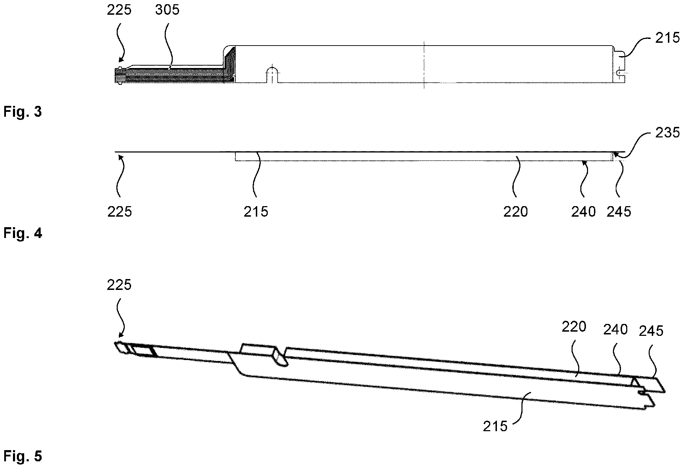

Figure 3 shows a view of an operating element 215 according to the embodiment of Figure 2. Facing the viewer is a surface of the operating element 215, which in Figure 2 is connected to the foam element 220. It can be seen that a plurality of conductive tracks 305 are provided on the conductive foil 215, each of which extends to the electrical connection 225. A conductor track 305 can form an electrode structure, for example in the form of a spiral or a meander. The electrode structure can be essentially as large as a fingertip if a button-like operation is desired. In another embodiment, an elongated structure may also be provided, for example, which can be used to determine a position of a part of a user's body along the structure.

In the embodiment shown, the electrode structures on the operating element 215 are covered, for example by means of a film or a layer of paint. The cover is electrically insulating and can have dielectric properties which can advantageously be utilized to determine contact.

Figure 4 shows a further view of an operating element 215 corresponding to the embodiment of Figures 2 and 3. The view shown emerges from the view of Figure 3 by tilting the operating element 215 upwards. It can be seen that the operating element 215 is thinner than the foam element 220. The foam element 220 extends essentially over the entire area of the operating element 215, which is intended to lie between the retaining element 205 and the transparent panel 125.

Figure 5 shows a further view of an operating element 215 according to the embodiments of Figures 2 to 4. In this embodiment, the protective film 245 covering the second double-sided adhesive film 240, which is attached to the foam element 220, is recognizable.

### Reference sign

- 100: Household appliance
- 105: Interaction device
- 110: Front panel
- 115: Recess
- 120: Recess
- 125: Transparent panel

- 205: Retaining element
- 210: Optical display
- 215: Operating element
- 220: Foam element
- 225: Electrical connection
- 230: Control unit

- 235: first double-sided adhesive film
- 240: second double-sided adhesive film
- 245: Protective film

- 305: Conductor track

## Claims

1. An interaction device (105) for a household appliance (100), the interaction device (105) comprising the following elements:
- a retaining element (205);
- an operating element (215); and
- a foam element (220), which is arranged flat between the retaining element (205) and the operating element (215);
- wherein the retaining element (205) is adapted to be attached to the household appliance (100) in such a way that the operating element (215) rests against a transparent panel (125) of the household appliance (100) and the foam element (220) is compressed between the retaining element (205) and the transparent panel (125).

2. The interaction device (105) according to claim 1, wherein the operating element (215) comprises a capacitive button.

3. The interaction device (105) according to claim 1 or 2, wherein the foam element (220) is dimensioned such that a contact force between the transparent panel (125) and the operating element (215) lies within a predetermined range.

4. Interaction device (105) according to one of the preceding claims, wherein the transparent panel (125) and the operating element (215) abut each other along a plane.

5. The interaction device (105) according to any one of the preceding claims, wherein the operating element (215) comprises a flexible conductive foil with a conductive track (305).

6. Interaction device (105) according to one of the preceding claims, wherein the foam element (220) is connected to the operating element (215) in a planar manner.

7. Interaction device (105) according to one of the preceding claims, wherein the foam element (220) is connected to the retaining element (205) in a planar manner.

8. Interaction device (105) according to claim 6 or 7, wherein the foam element (220) is connected by means of a double-sided adhesive film (235, 240).

9. Interaction device (105) according to one of the preceding claims, wherein an optical display (210) is attached to the retaining element (205) and the optical display (210) is arranged to be viewed through the transparent panel (125).

10. Interaction device (105) according to claim 9, wherein the optical display (210) is flush with the operating element (215).

11. The interaction device (105) according to any one of claims 9 or 10, further comprising a control device (230) arranged to control the household appliance (100) in dependence on an operation of the operating element (215) and a content displayed on the display in the area of the operation.

12. A household appliance (100) comprising an interaction device (105) according to any one of the preceding claims.

13. The household appliance (100) according to claim 12, wherein the transparent panel (125) is comprised by an appliance front (110) of the household appliance (100).
